# EUROPÄISCHE PATENTSCHRIFT

(11) **EP 0 824 759 B1**
(45) Veröffentlichungstag und Bekanntmachung des Hinweises auf die Patenterteilung: **16.06.1999**
(21) Anmeldenummer: 96908991.1
(22) Anmeldetag: 22.04.1996
(51) Int. Cl.: H01J 37/28, G01N 1/32

(54) **IONENSTRAHLPRÄPARATIONSVORRICHTUNG FÜR DIE ELEKTRONENMIKROSKOPIE**
ION BEAM PREPARATION DEVICE FOR ELECTRON MICROSCOPY
DISPOSITIF DE PREPARATION DE FAISCEAUX D'IONS POUR MICROSCOPIE ELECTRONIQUE

(30) Priorität: 29.04.1995 DE 29507225 U
(43) Veröffentlichungstag der Anmeldung: 25.02.1998
(73) Patentinhaber: BAL-TEC AG, 9496 Balzers (LI)
(72) Erfinder: GRÜNEWALD, Wolfgang, D-09122 Chemnitz (DE)
(74) Vertreter: Wegmann, Urs
(86) Internationale Anmeldenummer: CH9600145
(87) Internationale Veröffentlichungsnummer: WO9635226

(56) Entgegenhaltungen:
- EP-A- 0 687 897
- DE-U- 29 507 225
- US-A- 4 128 765
- PATENT ABSTRACTS OF JAPAN Bd. 018, Nr. 595 (E-1630) 14 November 1994 & JP,A,06 231 720 (SEIKO INSTR INC) 19 August 1994
- PATENT ABSTRACTS OF JAPAN Bd. 010, Nr. 324 (P-512) 05 November 1986 & JP,A,61 130 848 (HITACHI NAKA SEIKI KK) 18 Juni 1986
- PATENT ABSTRACTS OF JAPAN Bd. 96, Nr. 001 & JP,A,08 005 528 (SHARP CORP) 12 Januar 1996

## Beschreibung

Gegenstand der Erfindung ist eine Ionenstrahlpräparationsvorrichtung für die Bearbeitung von Proben für die Elektronenmikroskopie mit einer Vakuumkammer und mindestens einer Ionenquelle zum Beschiessen einer Probe in einem Probenhalter mit einem Edelgasionenstrahl insbesondere mit Argonionen.

Für die elektronenmikroskopische Beobachtung von Proben müssen diese in geeigneter Weise z.B. durch Ionenstrahlätzung präpariert werden (D.G.Howitt, Ion Milling of Materials Science Specimens for Electron Microscopy: A Review, Journal of Electron Microscopy Technique 1: 405-414 (1984); A.Garulli, A.Armigliato, M.Vanzi, Preparation of Silicon Specimens for Transmission Electron Microscopy, J. Microsc. Spectrosc. Electron. Vol.10, No 2, 1985, 135-144).

Das Ionenstrahlätzen zur Präparation von Proben für die Rasterelektronenmikroskopie (REM) und die Transmissionselektronenmikroskopie (TEM) ist eine Methode, die besonders dort eingesetzt wird, wo die konventionellen chemischen und elektrochemischen Verfahren versagen oder nur sehr unzureichende Präparationsergebnisse liefern. Das gilt besonders für die TEM-Querschnittspräparation von Material- und Schichtkombinationen mit stark selektiven Ätzverhalten und für chemisch resistente Materialien. Hier hat sich das Ionenstrahlätzen heute zu einer routinemässig genutzten Methode entwickelt.

Während man in den Anfängen die Querschnittsproben meist mit Transmissionselektronenmikroskopen mit 100 kV Beschleunigungsspannung untersuchte, ist man heute dazu übergegangen, Mittelspannungsgeräte mit 300 kV und Feldemissionsquellen (FEG) zu verwenden. Diese Geräte garantieren eine gleichmässigere Durchstrahlbarkeit der Querschnittsproben und sind in der Lage, Strahlsonden im nm-Bereich zu formen. Damit sind die technischen Voraussetzungen geschaffen, Strukturuntersuchungen und Materialanalysen (EELS, EDX) in kleinsten Bereichen, also auch an Nanostrukturen, durchzuführen.

Die Entwicklung der Nanotechnologie, d.h. die Erzeugung und Nutzung von Strukturen mit Abmessungen im Submikrometer- und Nanometerbereich (z.B. Halbleiter-Bauelementestrukturen), stellt neue wesentlich höhere Anforderungen an die Präparationstechniken. Die notwendige Zielpräparation von Strukturen mit extrem geringen Abmessungen macht eine wesentlich bessere Beobachtungsmöglichkeit der Probe während des Ätzvorganges erforderlich, um das jeweilige Stadium der Probenpräparation exakt beurteilen zu können.

Die heute bekannten konventionellen Ionenstrahlätzanlagen, wie z.B.:die RES 010 von BAL-TEC, die PIPS Modell 691 und die Dual Ion Mill von Gatan sowie die Ion Beam Thinning Unit von Technoorg LINDA verwenden zur Probenbeobachtung Lichtmikroskope mit einer maximal 100-fachen Vergrösserung. Dies ist meist schon bei der Querschnittspräparation von einfachen Mehrschichtsystemen unzureichend, da man den Zeitpunkt des Abbruchs des Ätzvorganges nicht genau bestimmen kann. Im Falle der Zielpräparation von ausgewählten Strukturen ist eine in situ-Beurteilung, ob sich die interessierende Struktur im abgedünnten Probenbereich befindet völlig unmöglich. Das gilt schon für Strukturen (auch für Wiederholstrukturen) im µm-Bereich! Die Folge ist ein aufwendiger "try and error"- Prozess, bei dem die Probe mehrfach zwischen Ätzanlage und Transmissionselektronenmikroskop bzw. den entsprechenden Probenhaltern transferiert werden muß. Häufig ist eine zerstörte Probe das Endergebnis.

Ein weiterer Nachteil der bekannten Ionenstrahlätzanlagen besteht in der schlechten Beherrschbarkeit des Endstadiums des Ätzvorganges. Weder die optische Beobachtungsmöglichkeit noch die von den bekannten Ionenstrahlätzanlagen verwendeten Abschaltautomatiken gestatten die Bestimmung des exakten Abbruchs des Ätzvorganges. Die verwendeten optischen und elektrischen Abschaltautomatiken sind nicht so sensibel, daß der Ätzvorgang rechtzeitig abgeschaltet wird. Das gilt besonders bei der Ionenstrahlpräparation von Querschnittsproben. Eine gewisse Verbesserung bietet die RES 010 von BAL-TEC, die einen speziellen Probenhalter mit eingebautem Faraday-Cup zur Detektion aller geladenen Teilchen nutzen. Dieser Aufbau schränkt allerdings die Möglichkeiten des Probenhalters stark ein, da die Probe nicht rückseitig gedünnt und beobachtet werden kann.

In bekannten Ionenstrahlpräparationsvorrichtungen werden die Proben während des Ätzvorganges üblicherweise rotiert, um die Abtragungsgleichmässigkeit zu erhöhen. Aus der Patentschrift US 4,128,765 ist ausserdem bekanntgeworden, die Probe nicht nur zu Rotieren, sondern während dem Ätzvorgang den Einfallswinkel des Ionenstrahles zu verändern. Der Einfallswinkel soll während dem Ätzen laufend nach einer Zufallsfunktion verändert werden. Dies wird dadurch erreicht, dass die Ionenquellen starr angeordnet sind und der Probenhalter mit der Probe gegenüber dem einfallenden Ionenstrahl um einen bestimmten Winkel gependelt wird. Nach Beendigung des Ätzvorganges ist die Probe dann bereit für die elektronenmikroskopische Beobachtung.

Neben der beschriebenen konventionellen Ätztechnik existiert eine weitere Technik, die ursprünglich zur Fehleranalyse von Schaltkreisen der Mikroelektronik entwickelt wurde. Mit Hilfe eines gerasterten, feinfokussierten (Ø im nm-Bereich) Ionenstrahls kann die Probe gezielt geätzt und mittels Ionenmikroskopie auch beobachtet werden. Diese fokussierte Ionenstrahl-Technik (FIB) wird heute auch zur Präparation von Proben für die Rasterelektronenmikroskopie (REM) und die Transmissionselektronenmikroskopie genutzt. Dazu werden die interessierenden Probenbereiche unter Verwendung von Ga-Flüssigmetall-Ionenquellen mit extrem hohen Ionenstromdichten von bis zu 10 A/cm² einseitig (Böschung für die REM-Untersuchung) oder zweiseitig (Stege für die TEM-Untersuchung) angeschnitten. Die in situ Beobachtung des Ätzvorganges erfolgt mit den durch den Ionenstrahl ausgelösten Sekundärteilchen (z.B. Hitachi FB 2000, FEI FIB 200,600 und 800) und neuerdings auch durch ein zusätzliches Rasterelektronenmikroskop (FEI Dual Beam FIB / SEM workstation). Der feinfokussieret Ionenstrahl und eine exakte Positionierungsmöglichkeit von Probe und Ionenstrahl ermöglichen eine genaue Zielpräparation der Probe. Das nur bei ruhender Probe mögliche Ionenstrahlätzen führt allerdings zu starken Vorzugsstrukturierungen an den Ätzböschungen. Besonders nachteilig wirkt sich das bei Mehrschichtsystemen mit stark selektivem Ätzcharakter aus. Der Einsatz der notwendigen hohen Ionenstromdichten hat eine starke Rückbeschichtung der Ätzböschungen und eine hohe lokale Aufheizung der Probe zur Folge. TEM-Proben können nur als ca. 100 nm dicke Stege hergestellt werden, was eine hochaufgelöste TEM-Untersuchung (HRTEM) an ausgewählten Probenbereichen unmöglich macht. Da die Stege durch starke Seitenwände des verbliebenen Probenmaterials fixiert werden müssen, ist eine Kippung der Probe im TEM zur exakten Probenorientierung aufgrund der Abschattungseffekte nur in einem sehr begrenzten Masse möglich. Zur Herstellung von TEM-Proben ist eine Beschichtung der Probenoberfläche notwendig. Diese FIB-Technik (fokussierte Ionenstrahltechnik) ist beispielsweise bekannt geworden aus der japanischen Patentanmeldung JP 6231720 entsprechend dem US-Patent US 5,525,806. Ein stark fokussierter Ionenstrahl wird gerastert über das zu bearbeitende Substrat geführt unter einem Winkel von 90°, wobei quaderförmige Bereiche aus dem Substrat herausgearbeitet werden, um dünne Stege, welche den interessierenden Bereich bilden, für die nachfolgende TEM-Untersuchung zu hinterlassen. Die Anordnung mit dem gerasterten Ionenstrahl wird gleichzeitig als STM, d.h. als Ionenmikroskop, betrieben, um den Ätzvorgang verfolgen zu können. Nachdem beidseits des interessierenden stegförmigen. Bereiches genügend geätzt worden ist, ist der interessierende Bereich, wie dies in Fig. 6 dargestellt ist, freigelegt und die Ionenquelle kann abgeschaltet werden, um anschliessend mit dem REM die Probe zu untersuchen. Eine simultane Beobachtung der Probe während des Ätzens ist nur bei der Dual Beam von FEI im REM-Modus möglich. Bei allen anderen Geräten muß die Probe in eine Beobachtungsposition gebracht werden und kann nur mit dem Ionenmikroskop beobachtet werden. Das hat auch bei verringerter Ionenstromdichte und Beschleunigungsspannung den Nachteil, dass während der Beobachtung Material von der interessierenden Probenstelle abgetragen oder Beschussionen implantiert werden, wodurch es zu einer Veränderung des Ausgangsmaterials der Probe kommt.

Der Erfindung liegt die Aufgabe zugrunde, die Nachteile des Standes der Technik zu beseitigen, insbesondere aber Proben unter ständiger, präziser Kontrolle wirtschaftlich mit wenig Ausschuss zu ätzen.

Die Aufgabe wird erfindungsgemäss durch die Vorrichtung nach Anspruch 1 gelöst. Die abhängigen Ansprüche definieren weitere vorteilhafte Ausführungsformen.

Die Vorrichtung gemäss Anspruch 1 zur Präparation von Proben für die Transmissions- und die Rasterelektronenmikroskopie ermöglicht eine rasterelektronenmikroskopische Beobachtung der Probe während des Ätzvorganges im REM- und Transmissionsrasterelektronenmikroskopie (TREM)-Modus und erlaubt damit ständig Aussagen über das jeweilige Ätzstadium sowie eine exakte optische Bestimmung des Zeitpunktes des Abbruchs des Ätzvorganges und die automatische Abschaltung der Probendünnung mittels der von einem Elektronendetektor (TE-Detektor) registrierten transmittierten Elektronen, ohne dabei die Präparationsmöglichkeiten der Vorrichtung einzuschränken.

Die Vorrichtung gemäss Anspruch 1 besteht dazu aus einer Vakuumkammer mit einem Pumpensystem, mindestens einer Ionenquelle zum Beschiessen der Probe in einem Probenhalter mit Edelgasionen, vorzugsweise mit Argonionen, wobei für höhere Ätzgeschwindigkeiten und damit kürzere Präparationszeiten auch mehr als eine, vorzugsweise zwei Ionenquellen verwendet werden können. Der Probenhalter ermöglicht eine Rotation und eine Kippung der Probe. Durch die Probenrotation wird eine homogene Abtragung der Probenoberfläche während des Ionenstrahlätzens erreicht und die Möglichkeit der Probenkippung erhöht die Variationsbreite der Präparationsparameter, wie z.B. der Beschusswinkel.

Auf dem Rezipienten ist die Säule eines Rasterelektronenmikroskops angebracht, deren Längsachse auf die Probe gerichtet ist. Mindestens ein erster Elektronendetektor, bestehend beispielsweise und vorzugsweise aus Szintilator, Lichtleiter und Fotomultiplier, zur Registrierung der Sekundärelektronen (SE-Detektor) ist zur Längsachse der REM-Säule verkippt angeordnet, wodurch Probenhalter und Dektor bei unterschiedlichen Kippwinkeln des Probenhalters ständig in günstiger Position bezüglich eines ausreichenden Elektronen-Signals für den SE-Detektor stehen. Damit kann im Gegensatz zum Stand der Technik die Probe in einer Auflösung im nm-Bereich beobachtet werden, wodurch eine genaue Beurteilung des Stadiums des Präparationsvorganges möglich ist, was besonders bei der gezielten Präparation von kleinsten Strukturen (Zielpräparation) von fundamentaler Bedeutung ist.

Ein zweiter Elektronendetektor, vorzugsweise ein Halbleiterdetektor, zur Registrierung der transmittierten Elektronen (TE-Detektor) ist in Achsrichtung der REM-Säule hinter der Probe angeordnet und ermöglicht eine transmissionsrasterelektronenmikroskopische (TREM) Abbildung der durchstrahlbaren Bereiche der abzudünnenden Probe. Dadurch kann in situ bei einer Auflösung im nm-Bereich entschieden werden, wie gut die Probe durchstrahlbar ist, ob sich im Falle einer Zielpräparation die interessierenden Strukturen im elektronentransparenten Bereich der Probe befinden und ob der Ätzvorgang weitergeführt oder abgebrochen werden soll. Die Strukturen können durch eine Linienbreitenmessung, realisierbar durch die Software des Rasterelektronenmikroskops, in situ ausgemessen und damit unterschieden werden. Die Möglichkeit der in situ -Beurteilung des Präparationsergebnisses und des Ätzendpunktes unmittelbar in der Ionenstrahlätzvorrichtung stellt gegenüber dem Stand der Technik einen weiteren grossen Vorteil dar.

Zu diesem Zweck ist der TE-Detektor mit einer Steuervorrichtung verbunden, die mit der Stromversorgung der Ionenquellen gekoppelt ist und bei Registrierung eines vorgegebenen Detektorstromes die Ionenquellen abschalten kann. Diese Abschaltautomatik ist wesentlich sensibler als die bekannten Abschaltautomatiken und unterbricht den Ätzvorgang bevor beispielsweise ein Loch in der Probe entsteht.

Das Mikroskop und die Elektronendetektoren werden während des Ätzvorganges der Probe vorzugsweise durch verschliessbare Blenden vor Verschmutzung geschützt. Der Schutz der empfindlichen Teile der Elektronendetektoren und des Rasterelektronenmikroskops erhöht die Reproduzierbarkeit der Probenbeobachtung und die Standzeiten zwischen den Reinigungen wesentlich.

Der Probenhalter ist durch seine Bewegungsmöglichkeit in x,y,z-Richtung bezüglich der Achsrichtung des Mikroskops zentrierbar und der Arbeitsabstand zwischen Mikroskop und Probenhalter einstellbar, wodurch die Probe aus der Präparationsposition in den optimalen Arbeitsabstand des Mikroskops und danach wieder in die voreingestellte Ausgangsposition gebracht werden kann.

Die verwendeten Ionenquellen liefern einen starren, fokussierten Edelgasionenstrahl mit Ionenstromdichten unter 100 mA/cm², vorzugsweise unter 30 mA/cm², um eine kurze Ätzzeit bei schonender Probenpräparation zu erreichen.

Direkt unter der Austrittsöffnung des Rasterelektronenmikroskops kann beispielsweise ein dritter Elektronendetektor, vorzugsweise ein Halbleiterdetektor, zur Registrierung der rückgestreuten Elektronen (RE-Detektor) angebracht werden, womit die Probenabbildung zusätzlich und wahlweise im Massenkontrast oder Topografiekontrast abgebildet werden kann.

Mindestens eine Ionenquelle, vorteilhafterweise zwei Ionenquellen sind schwenkbar gegenüber dem Probenhalter angeordnet, wodurch eine grosse Variationsbreite der Präparationsbedingungen wie der Beschusswinkel der Probe sowie die einseitige Probenätzung und auch die simultane beidseitige Probenätzung möglich sind.

Die Erfindung hat den Vorteil, daß REM-Säule, Elektronendetektoren, Ionenquellen und der Probenhalter so angeordnet sind, daß die Ionenstrahlpräparation der Probe unabhängig von den in der Vorrichtung wählbaren Präparationsbedingungen jederzeit in situ beobachtet werden kann, ohne den Präparationsvorgang zu unterbrechen.

Ein an der Vakuumkammer angebrachtes Lichtmikroskop dient zur Beobachtung der Justierung des Ionenstrahls bezüglich der Probe. Wegen der geforderten Präzision kann diese Justierung nur mit Hilfe eines Lichtmikroskops vorgenommen werden.

Bei der REM-Beobachtung von isolierenden Proben während ihrer Ionenstrahlbearbeitung kompensieren die Beschußionen die negative Probenaufladung durch den Elektronenstrahl des REM's. Bei der Ionenstrahlbearbeitung von isolierenden Proben ist es von Vorteil, die durch die Beschussionen erzeugte positive Aufladung durch den Elektronenstrahl des REM's zu kompensieren, weil dadurch eine unbeeinflusste Probenpräparation und gleichzeitig eine störungsfreie Abbildung der Probe möglich wird.

Wird eine isolierende Probe im optimalen Arbeitsabstand des REM's bei ausgeschalteten Ionenquellen untersucht, so kann die negative Probenaufladung mittels einer Elektronenquelle, die auf die Probe gerichtet ist und mit Elektronen im Energienbereich von 300 eV bis 1500 eV, vorzugsweise 400 eV bis 1000 eV arbeitet, kompensiert werden. Elektronen in diesem Energiebereich haben eine Sekundärelektronenausbeute >1 und erzeugen dadurch einen Elektronenmangel in der Probe, was zur Kompensation ihrer negativen Aufladung führt.

Die Erfindung wird nachfolgend anhand eines Ausführungsbeispieles unter Bezugnahme auf die Zeichnungen näher erläutert. Es zeigen:
- Fig. 1: den schematischen Aufbau der Vorrichtung zur Ionenstrahlpräparation von Proben für die Elektronenmikroskopie mit einer REM-Beobachtungsmöglichkeit
- Fig. 2: die schematische Anordnung von REM-Säule,Probenhalter in waagerechter Position, SE-Detektor, RE-Detektor, TE-Detektor und Blenden
a Bei der Präparation der ersten Probenseite kann die Probe mittels SE-Detektor und RE-Detektor beobachtet werden.
b Die Probe befindet sich zur hochaufgelösten Beobachtung im optimalen Arbeitsabstand des REM's.
c Bei der Präparation der zweiten Probenseite bis zur Elektronentransparenz der Probe kann die Probe sowohl mit dem SE-Detektor und RE-Detektor als auch mit dem TE-Detektor beobachtet werden. Erfolgt die Enddünnungs kontrolle mit dem TE-Detektor, wird eine Blende vor die REM-Säule und den SE-Detektor gebracht, die diese vor Verschmutzung durch das Ionenstrahlätzen schützt.

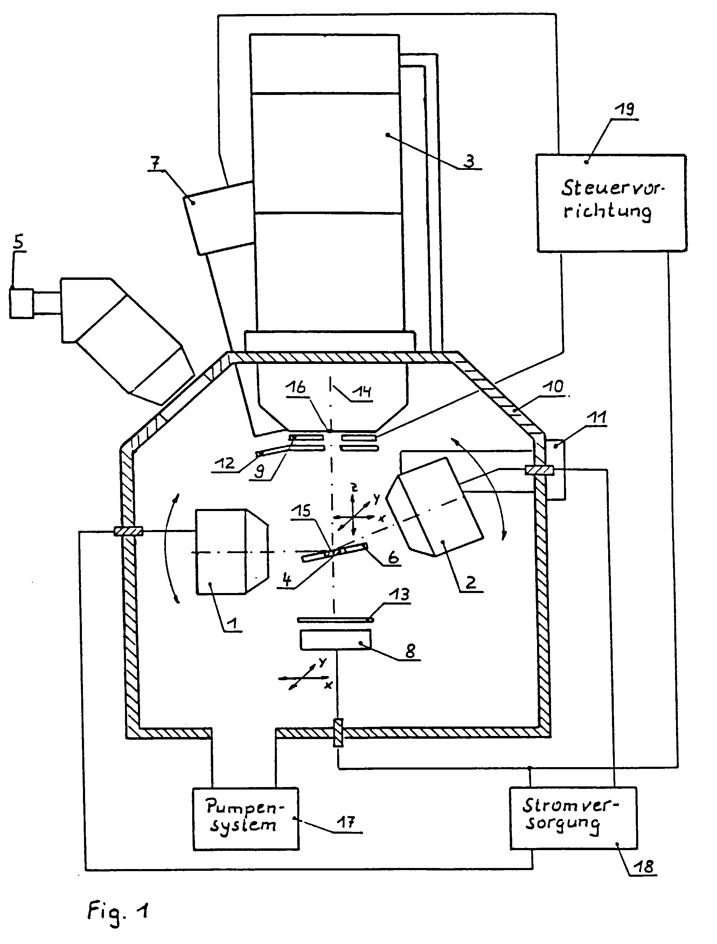

Ein Ausführungsbeispiel der erfindungsgemässen Vorrichtung zur Ionenstrahlpräparation von Proben für die Elektronenmikroskopie mit rasterelektronenmikroskopische Beobachtungsmöglichkeit ist in Fig. 1 schematisch dargestellt.

Die Säule des REM's 3 steht senkrecht auf einer Vakuumkammer 10, die durch ein Pumpensystem 17 auf einen Enddruck von 1.33·10⁻⁶ mbar (10⁻⁶ Torr) evakuiert werden kann. Die REM-Säule 3 ragt 90 mm in die Vakuumkammer, wobei ihre Längsachse 14 auf die Probe 4 in einem Probenhalter 6 gerichtet ist.

Der Probenhalter 6 ist in einem Abstand von 50 mm zur Unterseite der REM-Säule 3 vorteilhafterweise an einem 5-Achsen Probentisch befestigt, der folgende Bewegungsmöglichkeiten hat:
- Rotation und Pendelbewegung der Probe 4
- Kippung um die Längsachse des Probenhalters 0° - 360°
- x-Bewegung ± 15 mm
- y-Bewegung ± 15 mm
- z-Bewegung + 40 mm (Bewegungsrichtung Probenhalter 6 /REM-Säule 3)

Zwei gegenüberliegend positionierte Ionenquellen 1 und 2, beispielsweise Sattelfeld-Ionenquellen, die mit Beschleunigungsspannung von 1-10 kV bei Ionenstromdichten bis 20 mA/cm² und einem Strahldurchmesser von ca. 0,5 mm arbeiten und deren Strahl auf die Probe 4 gerichtet ist, sind bezüglich des Probenhalters 6 beweglich, wobei der Probenhalter 6 und die Ionenquellen 1,2 um eine zentrale Drehachse 15 zueinander schwenkbar angeordnet sind. Der Einsatz von zwei Ionenquellen ist von Vorteil, weil dadurch die Präparationszeiten verringert und die Variationsmöglichkeiten der Präparationsbedingungen erhöht werden. Die Ionenquellen 1,2 können gemeinsam oder einzeln um die zentrale Drehachse 15 und einzeln um weitere Drehachsen geschwenkt werden.

Um einen Winkel von 45° zur Längsachse der REM-Säule 3 verkippt befindet sich ein Lichtmikroskop 5, das vorrangig zur Beobachtung der Justierung des Ionenstrahls bezüglich der Probe 4 verwendet werden kann.

Ein Sekundärelektronen-Detektor 7 ,vorzugsweise vom Everhart-Thornley-Typ, ist um 45° zum Lichtmikroskop 5 versetzt und unter einem Winkel von 60° zur Längsachse 14 des REM's angebracht, wodurch unabhängig von den in der Vorrichtung verwendbaren Kippwinkeln des Probenhalters 6 ständig eine günstige Position des SE-Detektors 7 zur Probe 4 bezüglich der Detektion der Sekundärelektronen und damit der Abbildung der Probenoberfläche möglich ist.

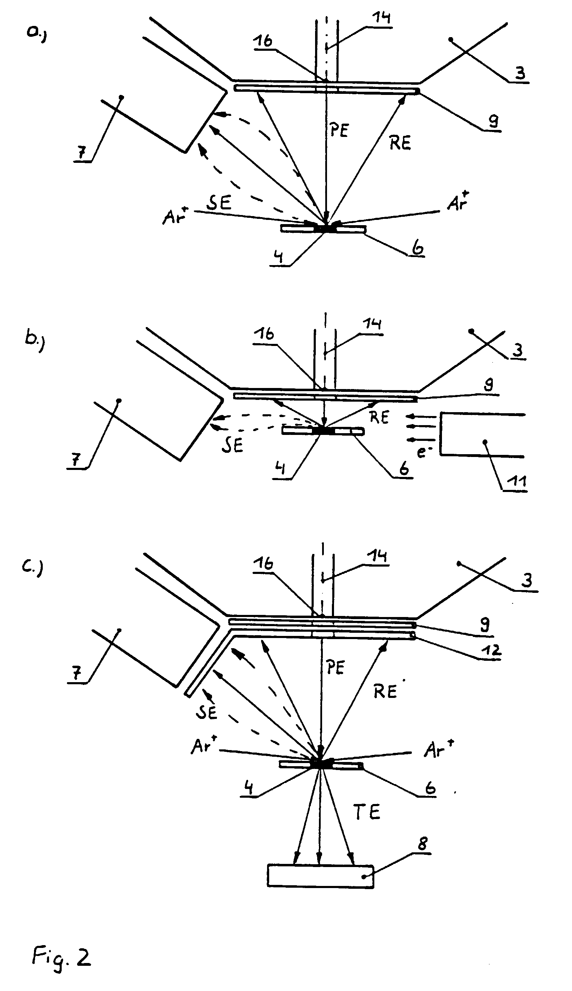

Die Probe 4 kann gemäss Fig. 2a zu jedem Zeitpunkt des Ätzvorganges unabhängig von den wählbaren Präparationsbedingungen der Vorrichtung und ohne Unterbrechung des Ätzvorganges in situ mit der hohen Auflösung des Rasterelektronenmikroskop's beobachtet werden. Das ergibt den Vorteil, daß jederzeit Aussagen über den Stand der Probenpräparation in z-Richtung und über die Genauigkeit einer Zielpräparation in der x,y-Ebene möglich sind.

Die Beschusswinkel können bei dem beschriebenen Aufbau der Vorrichtung wie folgt variiert werden:

Bei einer Kippung des Probenhalters 6 um 15° zum Lichtmikroskop 5 hin kann der Beschusswinkel der ersten Ionenquelle 1 von -20° bis 40° und der Beschusswinkel der zweiten Ionenquelle 2 von -40° bis 15° variiert werden, wobei 0° einem zur Probenoberfläche paralellen Ioneneinfall entspricht.

Wird nur die erste Ionenquelle 1 verwendet, kann der Ioneneinfallswinkel bezüglich der Probe 4 bei einer Kippung des Probenhalters 6 um 45° aus der waagerechten Position zwischen 0° und 70° variiert werden. Dabei bleibt die Probe 4 immer in einer günstigen Beobachtungsposition zum REM.

Zur höher aufgelösten Beobachtung der Probenoberfläche kann die Probe 4 aus der Präparationsposition über einen Verfahrweg von 40 mm in den optimalen Arbeitsabstand des Rasterelektronenmikroskops von 8 - 10 mm gemäss Fig. 2b gebracht werden und nach der Untersuchung wieder in die exakte, voreingestellte Ausgangsposition, ohne die Anordnung der Ionenquellen oder die Probenhalterkippung verändern zu müssen.

Direkt neben der REM-Säule 3 befindet sich eine auf die Probe 4 gerichtete Elektronenquelle 11, die Elektronen mit Energien von 400 eV bis 1000 eV liefert und zur Entladung isolierender Proben während der REM-Beobachtung im optimalen Arbeitsabstand dient.

Unter der Probe befindet sich ein zweiter, in x,y -Richtung verschiebbarer Elektronendetektor 8, vorzugsweise ein Halbleiterdetektor, zur Registrierung der transmittierten Elektronen, der bei der Dünnung der zweiten Probenseite im Endstadium des Abdünnvorganges gemäss Fig. 2c verwendet wird und über eine Steuervorrichtung 19, beispielsweise einer Computersteuerung, mit der Stromversorgung 18 der Ionenquellen gekoppelt ist. Wird die Probe 4 elektronentransparent, so ist das auf dem Monitor des Rasterelektronenmikroskops wahlweise in Hell-und Dunkelfeldabbildung im TREM-Modus beobachtbar und die Ionenquellen werden mit Hilfe des registrierten Detektorstroms nach vorgegebenen Wert abgeschaltet. Im Gegensatz zu den bekannten Lösungen arbeitet diese Abschaltautomatik sehr sensibel und unterbindet eine unerwünschte Lochbildung in der Probe.

Danach kann im hochaufgelösten TREM-Modus beurteilt werden, ob sich die interessierenden Strukturen im durchstrahlbaren Bereich der Probe 4 befinden und ob die Probe 4 weiter abgedünnt oder der Ätzvorgang beendet werden soll. Die Strukturen können mittels Linienbreitenmessung über die Software des Rasterelektronenmikroskops in situ ausgemessen und damit unterschieden werden.

Ein als Halbleiter-Quadranten-Detektor ausgeführter RE-Detektor 9 ist direkt unter der Rasterelektronenmikroskopaustrittsöffnung 16 angeordnet, wodurch die Probenoberfläche wahlweise im Massenkontrast oder Topografiekontrast abgebildet werden kann.

Die Vorrichtung gestattet somit jederzeit eine optimale Kontrolle des Ätzvorganges, was besonders bei der gezielten Dünnung ausgewählter Strukturen (Zielpräparation) von Bedeutung ist, und ermöglicht es, den Ionenstrahlätzvorgang im richtigen Moment abzubrechen.

Ein weiterer Vorteil der erfindungsgemässen Vorrichtung besteht darin, daß aufgrund der hohen Variationsbreite der Beschusswinkel und der verschiedenen Bewegungsmöglichkeiten des Probenhalters 6 sowohl Proben für die Transmissionselektronenmikroskopie (lateral abgedünnte Proben und Querschnittsproben) als auch Proben für die Rasterelektronenmikroskopie (z.B. Ätzböschungen) mit hoher Präzision definiert hergestellt werden können.

Die REM-Säule 3 und die Elektronendetektoren 7,8,9 können während des Ätzvorganges durch einschwenkbare Blenden 12,13 vor Verschmutzung durch abgestäubtes Probenmaterial geschützt werden, wobei die Blende 12 für die REM-Säule eine Öffnung für den Elektronenstrahl hat und somit das Endstadium des Abdünnvorganges mittels TE-Detektor 8 trotzdem ständig konntrollierbar ist. Im folgenden sollen zwei Beispiele für mit der beschriebenen Anordnung präparierten Proben vorgestellt werden:

Beispiel 1 betrifft die laterale Präparation einer Halbleiter-Bauelementestruktur. Die Probe wurde mechanisch von der Substratseite bis zu einer Ausgangsdicke für das Ionenstrahlätzen von 35 µm abgedünnt. Das Ionenstrahlätzen erfolgte substratseitig mit zwei Ionenquellen unter einem Beschusswinkel von 6° zur Probenoberfläche und einer Beschleunigungsspannung von 9,8 kV unter REM-Kontrolle bis zur Elektronentransparenz der Probe.

Das zweite Beispiel betrifft die Querschnittspräparation einer Kontaktlochstruktur eines Mehrebenenleitbahnsystems. Die Ausgangsdicke der Probe, erzielt durch die mechanische Vorpräparation, betrug 35 µm. Die Probe wurde dann von der ersten Seite mit einer Ionenquellen unter einem Beschusswinkel von 4° und einer Beschleunigungsspannung von 8kV bei oszillierender Probenbewegung unter REM-Kontrolle bis zu einer vorbestimmten Tiefe abgedünnt. Die Ionenstrahlpräparation der zweiten Probenseite bis zur Elektronentransparenz der Probe erfolgte in gleicher Weise. Das Endstadium des Abdünnvorganges beider Proben konnte mit Hilfe des TE-Detektors erfolgreich beherrscht werden. Sobald die Proben elektronentransparent waren, erschien ein Bild mit den interessierenden Strukturen auf dem Monitor des REM's und der Ätzvorgang konnte rechtzeitig abgebrochen werden.

## Patentansprüche

1. Ionenstrahlpräparationsvorrichtung für die Bearbeitung von Proben (4) für die Elektronenmikroskopie mit einer Vakuumkammer (10) und mindestens einer Ionenquelle (1, 2) zum Beschiessen einer Probe (4) in einem Probenhalter (6) mit einem Edelgasionenstrahl insbesondere mit Argonionen, wobei Mittel vorgesehen sind, den Ionenstrahl stationär unter einem bestimmten vorgegebenen Winkel auf der Probe (4) auftreffen zu lassen und wobei der Probenhalter (6) rotierbar und verkippbar angeordnet ist, dadurch gekennzeichnet dass die Vakuumkammer (10) eine REM-Säule (3) aufweist, deren Achse (14) auf die Probe (4) gerichtet ist, wobei mindestens ein erster REM-Detektor (7) mit Mitteln zur Abbildung der Probenoberfläche und ein zweiter REM-Detektor (8) mit Mitteln für die Abbildung im TREM-Modus durch die Registrierung von die Probe transmittierenden Elektronen vorgesehen sind.

2. Vorrichtung nach Anspruch 1 dadurch gekennzeichnet, dass der zweite Detektor (8) in Achsrichtung (14) des Elektronenmikroskopes (3) hinter der Probe (4) angeordnet ist.

3. Vorrichtung nach Anspruch 2 dadurch gekennzeichnet, dass der zweite Detektor (8) mit einer Steuervorrichtung (19) verbunden ist, wobei diese mit der Ionenquelle (1,2) so gekoppelt ist, dass die Ionenquelle (1,2) bei vorgegebenem Detektorstrom, vorzugsweise nach in der REM-Abbildung sichtbaren vorgegebenen Strukturelement entsprechend dem Probendünnungsgrad abgeschaltet wird.

4. Vorrichtung nach einem der Ansprüche 1 bis 3 dadurch gekennzeichnet, dass vor der Mikroskopöffnung (16) und mindestens vor dem ersten Detektor (7) eine verschliessbare Blende (12) angeordnet ist.

5. Vorrichtung nach einem der Ansprüche 1 bis 4 dadurch gekennzeichnet, dass der Probenhalter (6) die Probe (4) in Achsrichtung (14) des Mikroskops zentriert und der Arbeitsabstand zwischen Probe (4) und Mikroskop (3) einstellbar ist.

6. Vorrichtung nach einem der Ansprüche 1 bis 5 dadurch gekennzeichnet, dass der Probenhalter (6) fünfachsig ausgebildet ist.

7. Vorrichtung nach einem der Ansprüche 1 bis 6 dadurch gekennzeichnet, dass die Ionenstromdichte an der Probe (4) nicht grösser als 100 mA/cm² ist, vorzugsweise nicht grösser als 30 mA/cm².

8. Vorrichtung nach einem der Ansprüche 1 bis 7 dadurch gekennzeichnet, dass ein dritter REM-Detektor (9) als Rückstreuelektronendetektor ausgebildet ist und unmittelbar um die Rasterelektronenmikroskopaustrittsöffnung (16) angeordnet ist.

9. Vorrichtung nach einem der Ansprüche 1 bis 8 dadurch gekennzeichnet, dass mindestens eine Ionenquelle (1,2) schwenkbar gegenüber der Probe (4) angeordnet ist.

10. Vorrichtung nach einem der Ansprüche 1 bis 9 dadurch gekennzeichnet, dass an der Vakuumkammer (10) ein Lichtmikroskop (5) angeordnet ist zur Beobachtung der Justierung des Ionenstrahles bezüglich der Probe (4).

11. Vorrichtung nach einem der Ansprüche 1 bis 10 dadurch gekennzeichnet, dass die Vorrichtung eine Elektronenquelle (11) umfasst, welche auf die Probe (4) ausgerichtet ist, wobei die Elektronenquelle (11) Mittel umfasst zur Erzeugung von Elektronenenergien von 300 Elektronenvolt bis 1500 Elektronenvolt und vorzugsweise 400 Elektronenvolt bis 1000 Elektronenvolt.

## Claims

1. Ion beam preparation device for processing specimens (4) for electron microscopy, with a vacuum chamber (10) and at least one ion emission source (1, 2) for bombarding a specimen (4) in a specimenholder (6) with a beam of noble gas ions, in particular argon ions, providing means to direct the beam of ions in a stationary manner at the specimen (4) at a specific predefined angle, and whereby the specimen holder (6) can be rotated and tilted, **characterised in that** the vacuum chamber (10) has an REM column (3) whose axis (14) is directed at the specimen (4), whereby at least a first REM detector (7) is provided with means for imaging the surface of the specimen and a second REM detector (8) is provided with means for imaging in the TREM mode through registration of the electrons transmitted by the specimen.

2. Device according to claim 1, **characterised in that** the second detector (8) is located behind the specimen (4) in the axial direction (14) of the electron microscope (3).

3. Device according to claim 2, **characterised in that** the second detector (8) is connected to a control device (19) which in turn is connected to the source of the ions (1, 2) in such way that the ion source (1, 2) is shut down when a preset detector current level is attained, preferably based on the visibly predefined structureelements visible in the REM image in accordance with the degree of specimen thinning.

4. Device according to one of claims 1 to 3, **characterised in that** a shutter (12) which can be closed is provided in front of the microscope opening (16) and at least in front of the first detector (7).

5. Device according to one of claims 1 to 4, **characterised in that** the specimen holder (6) centres the specimen (4) in the axial direction (14) of the microscope and that the working distance between the specimen (4) and the microscope (3) can be adjusted.

6. Device according to one of claims 1 to 5, **characterised in that** the specimen holder (6) is mobile in five axes.

7. Device according to one of claims 1 to 6, **characterised in that** the ion current density on specimen (4) is not greater than 100 mA/cm², preferably not greater than 30 mA/cm².

8. Device according to one of claims 1 to 7, **characterised in that** a third REM detector (9) is designed as a back scatter electron detector and is arranged directly around the exit opening (16) of the scanning electron microscope.

9. Device according to one of claims 1 to 8, **characterised in that** at least one ion source (1,2) can be swiveled relative to specimen (4).

10. Device according to one of claims 1 to 9, **characterised in that** an optical microscope (5) is arranged at the vacuum chamber (10) for observing the alignment of the ion beam relative to the specimen (4).

11. Device according to one of claims 1 to 10, **characterised in that** the device comprises a electron source (11) which is aimed at the specimen (4) whereby the electron source (11) comprises means for generating electron energies of 300 electron volts up to 1500 electron volts and preferably 400 electron volts up to 1000 electron volts.

## Revendications

1. Dispositif de préparation de faisceaux ioniques pour le traitement d'éprouvettes (4) pour la microscopie électronique avec une chambre à vide (10) et au moins une source d'ions (1, 2) pour exposer une éprouvette (4) à un faisceau ionique de gaz rare, notamment avec des ions d'argon, dans un porte-échantillon (6), des moyens étant prévus pour que le faisceau ionique ait un angle d'impact stationnaire donné sur l'éprouvette (4), et le porte-échantillon (6) étant disposé de manière à assurer une rotation et un basculement, de telle sorte que la chambre à vide (10) présente une colonne REM (3) dont l'axe (14) est dirigé sur l'éprouvette (4), un premier détecteur REM (7), au moins, étant prévu avec des moyens permettant la représentation de la surface de l'éprouvette et un second détecteur REM (8) étant prévu avec des moyens permettant la représentation en mode TREM par l'enregistrement des électrons traversant l'éprouvette.

2. Dispositif selon la revendication 1, caractérisé par le fait que le second détecteur (8) est disposé dans le sens axial (14) du microscope électronique (3), derrière l'éprouvette (4).

3. Dispositif selon la revendication 2, caractérisé par le fait que le second détecteur (8) est relié à un dispositif de commande (19), ce dernier étant accouplé à la source d'ions (1, 2) de telle sorte que la source d'ions (1, 2), pour un courant donné du détecteur, soit désactivée de préférence après l'élément structurel donné visible dans la représentation REM, selon le degré d'amincissement de l'éprouvette.

4. Dispositif selon l'une des revendications 1 à 3, caractérisé par le fait qu'un cache verrouillable (12) est disposé devant l'ouverture du microscope (16) et au moins devant le premier détecteur (7).

5. Dispositif selon l'une des revendications 1 à 4, caractérisé par le fait que le porte-échantillon (6) centre l'éprouvette (4) dans le sens axial (14) du microscope et que la distance de travail entre l'éprouvette (4) et le microscope (3) est réglable.

6. Dispositif selon l'une des revendications 1 à 5, caractérisé par le fait que le porte-échantillon (6) a cinq axes.

7. Dispositif selon l'une des revendications 1 à 6, caractérisé par le fait que la densité du courant ionique au niveau de l'éprouvette (4) n'est pas supérieure à 100 mA/cm², de préférence pas supérieure à 30 mA/cm².

8. Dispositif selon l'une des revendications 1 à 7, caractérisé par le fait qu'un troisième détecteur REM (9) est prévu en tant que détecteur électronique de rétrodiffusion et est placé directement autour de l'orifice de sortie du microscope électronique à balayage (16).

9. Dispositif selon l'une des revendications 1 à 8, caractérisé par le fait qu'au moins une source d'ions (1, 2) est disposée de manière à être orientable par rapport à l'éprouvette (4).

10. Dispositif selon l'une des revendications 1 à 9, caractérisé par le fait qu'un microscope optique (5) est disposé au niveau de la chambre à vide (10) afin de pouvoir observer l'ajustage du faisceau ionique par rapport à l'éprouvette (4).

11. Dispositif selon l'une des revendications 1 à 10, caractérisé par le fait que le dispositif comprend une source d'électrons (11) orientée vers l'éprouvette (4), la source d'électrons (11) étant pourvue de moyens permettant la production d'énergies électroniques de 300 électronvolts à 1500 électronvolts et, de préférence, de 400 électronvolts à 1000 électronvolts.
